# EUROPEAN PATENT APPLICATION

(11) **EP 4 521 636 A1**
(43) Date of publication of application: **12.03.2025**
(21) Application number: 22963818.4
(22) Date of filing: 01.11.2022
(51) Int. Cl.: H03F 1/02

(54) **DOHERTY AMPLIFIER AND OUTPUT NETWORK THEREOF, AND DOHERTY AMPLIFIER DESIGN METHOD**

(71) Applicant: Suzhou Watech Electronics Co., Ltd., Suzhou, Jiangsu 215125 (CN)
(72) Inventor: LIU, Haoyu, Shanghai 200127 (CN); ZHENG, Shuangshuang, Shanghai 200127 (CN); LIN, Liang, Shanghai 200127 (CN)
(74) Representative: Michalski Hüttermann & Partner Patentanwälte mbB
(86) International application number: PCT/CN2022/128960
(87) International publication number: WO 2024/092499

(57) **Abstract**

Provided in the embodiments of the present application are an output network of a Doherty amplifier, the output network including: a combined node; a primary output network, which is connected between an output end of a primary amplifier of a Doherty amplifier and the combined node; a secondary output network, which is connected between an output end of a secondary amplifier of the Doherty amplifier and the combined node; and a combiner matching network, which is connected between the combined node and a radio-frequency output end of the Doherty amplifier, wherein the secondary output network includes a first sub-network and a second sub-network, which are connected in series, the first sub-network and the primary output network having the same circuit topology and each including at least an inductor and a capacitor, and the second sub-network including at least an inductor; the combiner matching network is configured to make a node impedance at the combined node be a complex impedance; and the primary output network and the secondary output network are respectively configured to make the node impedance match a target load impedance of the primary amplifier and a target load impedance of the secondary amplifier.

## Description

### TECHNICAL FIELD

The present disclosure relates to the field of wireless communications, more particularly to an output network of a Doherty amplifier, a Doherty amplifier comprising the output network, and a design method of the Doherty amplifier.

### BACKGROUND

With the development of wireless communication technology, the communication bandwidth required by wireless communication systems continues to increase, and the modulation signals used in wireless communication systems are becoming more and more complex. In order to meet the requirements of bandwidth, efficiency, and size of wireless communication systems, in the radio frequency front-terminal system of wireless communication networks, the efficiency, back-off power range, operating bandwidth, and size of the power amplifier (PA) are more and more demanding.

In related arts, Doherty amplifiers can be employed in the radio frequency front-terminal of wireless communication systems (comprising base stations, broadcasts, mobile terminals, etc.) to improve the efficiency of wireless communication systems. However because the number of radio frequency link units (power amplifiers and antennas, etc.) comprised by the radio frequency front-terminal systems continues to increase, and the Doherty amplifier has many components and a large circuit size, it is difficult to meet the design requirements of miniaturized amplifiers. In addition, because the load modulation of the Doherty amplifier is implemented by a quarter-wavelength transmission line, this structure leads to a narrow operating bandwidth and a small back-off power range in high-efficiency of the Doherty amplifier. Therefore, it is difficult for wireless communication systems to meet the increasingly high requirements in terms of bandwidth, efficiency, and size with the conventional Doherty amplifiers. At present, there are some methods to increase the bandwidth by improving the load modulation network of the Doherty amplifier, but the size of the Doherty amplifier is generally increased, which makes it difficult to achieve a good balance between the efficiency, bandwidth, back-off power range and circuit size of the amplifier.

### SUMMARY

In view of the above, the present disclosure provides an output network for a Doherty amplifier, a Doherty amplifier comprising the output network, and a design method of the Doherty amplifier to mitigate, decrease, or even eliminate the above problems.

The embodiments of the present disclosure provide an output network for a Doherty amplifier, the Doherty amplifier comprising a main amplifier and an auxiliary amplifier, the output network comprising a combination node, a main output network connected between an output port of the main amplifier and the combination node, an auxiliary output network connected between the output port of the auxiliary amplifier and the combination node, and a merging matching network connected between the combination node and a radio frequency output port of the Doherty amplifier, where the auxiliary output network comprises a first sub-network and a second sub-network connected in series, the first sub-network and the main output network having the same circuit topology and each at least comprising an inductor and a capacitor, and the second sub-network at least comprising an inductor, where the merging matching network is configured for the node impedance at the combination node being a complex impedance, the main output network and the auxiliary output network are configured for the node impedance being matching with the goal load impedances of the main amplifier and the auxiliary amplifier.

According to some embodiments of the present disclosure, the main output network is equivalent to a first transmission line in an operating frequency band, and the auxiliary output network is equivalent to a second transmission line in an operating frequency band, and an electrical angle θ_{M} of the first transmission line and the electrical angle θ_{A} of the second transmission line satisfy 70°<θ_{M}<90°, and 135°<θ_{A}<180°.

According to some embodiments of the present disclosure, the output network is configured for the output current I_{M} of the main amplifier and the output current I_{A} of the auxiliary amplifier satisfying an amplitude of the I_{M} is not larger than an amplitude of the I_{A} and a phase difference between the I_{M} and the I_{A} is less than 90°.

According to some embodiments of the present disclosure, the first sub-network and the main output network each comprise a first capacitor, a second capacitor, and a first inductor, one end of the first capacitor and one end of the first inductor being connected to the output port of the main amplifier or the auxiliary amplifier, the other end of the first capacitor being grounded, the other end of the first inductor being connected to one end of the second capacitor, and the other end of the second capacitor being grounded.

According to some embodiments of the present disclosure, each of the first sub-network and the main output network further comprise a third capacitor, one end of the third capacitor being connected to the output port of the main amplifier or the auxiliary amplifier, and the other end of the third capacitor being grounded.

According to some embodiments of the present disclosure, each of the first sub-network and the main output network further comprise a second inductor, one end of the second inductor being connected to an output port of the main amplifier or the auxiliary amplifier, and the other end of the second inductor being grounded.

According to some embodiments of the present disclosure, the second sub-network comprises a third inductor and a fourth capacitor, one end or the third inductor being connected to an output port of the first sub-network, the other end of the third inductor being connected to one end of the fourth capacitor, the other end of the fourth capacitor being grounded.

According to some embodiments of the present disclosure, the merging matching network comprises a fourth inductor, a fifth inductor, a sixth inductor, a fifth capacitor, and a sixth capacitor, one end of the fourth inductor being connected to the combination node, the other end of the fourth inductor being connected to one end of the fifth capacitor and one end of the fifth inductor, the other end of the fifth capacitor being grounded, the other end of the fifth inductor being connected to one end of the sixth capacitor and one end of the sixth inductor, the other end of the sixth capacitor being grounded, the other end of the sixth inductor being connected to a DC voltage port configured to provide a DC bias voltage to the main amplifier and the auxiliary amplifier via the sixth inductor, the fifth inductor, the fourth inductor, the main output network, and the auxiliary output network.

According to some embodiments of the present disclosure, the merging matching network comprises a third transmission line, a fourth transmission line, a fifth transmission line, a sixth transmission line, and a seventh capacitor, one end of the third transmission line being connected to the combination node, the other end of the third transmission line being connected to one end of the fourth transmission line and one end of the fifth transmission line, the other end of the fourth transmission line being connected to a DC voltage port and one end of the seventh capacitor, the other end of the seventh capacitor being grounded, the other end of the fifth transmission line being connected to one end of the sixth transmission line, the other end of the sixth transmission line being floating, the DC voltage port being configured to provide a DC bias voltage to the main amplifier and the auxiliary amplifier via the fourth transmission line, the third transmission line, the main output network and the auxiliary output network.

According to some embodiments of the present disclosure, the merging matching network comprises a seventh inductor, an eighth capacitor, a ninth capacitor, a tenth capacitor, a seventh transmission line, and an eighth transmission line, one end of the seventh inductor being connected to the combination node, the other end of the seventh inductor being connected to one end of the eighth capacitor and one end of the seventh transmission line, the other end of the eighth capacitor being grounded, the other end of the seventh transmission line being connected to one end of the ninth capacitor and one end of the eighth transmission line, the other end of the ninth capacitor being grounded, the other end of the eighth transmission line being connected to a DC voltage port, one end of the tenth capacitor being connected to the DC voltage port, the other end of the tenth capacitor being grounded, the DC voltage port being configured to provide a DC bias voltage to the main amplifier and the auxiliary amplifier via the eighth transmission line, the seventh transmission line, the seventh inductor, the main output network and the auxiliary output network.

According to some embodiments of the present disclosure, at least one of the first to the tenth capacitor can be implemented in at least one of a PCB surface mount element and an integrated circuit device.

According to some embodiments of the present disclosure, at least one of the first to the seventh inductor can be implemented in at least one of a PCB surface mount element, an integrated circuit device, a bonding wire, a microstrip line, a metal winding wire, a transmission line.

According to some embodiments of the present disclosure, at least one of the third to the eighth transmission line can be implemented in at least one of a microstrip line, a strip line, a coplanar waveguide, a substrate integrated waveguide.

Another embodiment of the present disclosure provides a Doherty amplifier comprising: a main amplifier; an auxiliary amplifier; and an output network according to any of the above embodiments, where the output network is configured to receive a first amplified signal outputted by the main amplifier and a second amplified signal outputted by the auxiliary amplifier, and the first amplified signal and the second amplified signal are combined at the combination node to be provided to a radio frequency output port of the Doherty amplifier.

Yet another embodiment of the present disclosure provides a design method of the Doherty amplifier, the Doherty amplifier comprising a main amplifier, an auxiliary amplifier, and an output network as claimed in claim 1, where the method comprises: setting a goal performance index of the Doherty amplifier, the goal performance index at least comprising an operating frequency, a saturation power, and a dynamic range of the Doherty amplifier; according to the goal performance index, selecting transistors for the main amplifier and the auxiliary amplifier; based on load traction testing or simulation analysis, determining a first goal impedance, a second goal impedance and a third goal impedance, where the first goal impedance is a load impedance maximizing the efficiency of the main amplifier when the Doherty amplifier is in a back-off power state, the second goal impedance is a load impedance maximizing the efficiency of the main amplifier when the output power of the main amplifier reaches saturation power, and the third goal impedance is a load impedance maximizing the efficiency of the auxiliary amplifier when the output power of the auxiliary amplifier reaches saturation power; based on the first goal impedance, the second goal impedance and the third goal impedance, determining a circuit topology and element parameters of each sub-network in the auxiliary output network and the main output network, and determining a circuit topology and element parameters of the merging matching network.

In the output network for the Doherty amplifier according to some embodiments of the present disclosure, a main output network, an auxiliary output network, and a merging matching network are provided, where the auxiliary output network comprises a first sub-network and a second sub-network connected in series, where the merging matching network is configured for the node impedance at the combination node being a complex impedance, and the main output network and the auxiliary output network are configured for the node impedance being matching with the goal load impedances of the main amplifier and the auxiliary amplifier, so that the Doherty amplifier can operate efficiently from low power to high power. On the other hand, the first sub-network and the main output network have the same circuit topology and each at least comprises an inductor and a capacitor, and the second sub-network at least comprises an inductor, thereby conducive to simplifying the structure of the output network of the Doherty amplifier and the corresponding design process.

These and other aspects of the present disclosure will be clearly understood in accordance with the embodiments described herein and will be elucidated with reference to the embodiments described herein.

### BRIEF DESCRIPTION OF THE DRAWINGS

In the following description of exemplary embodiments in conjunction with the drawings, further details, features, and advantages of the technical proposals of the present disclosure are disclosed, in the drawings:
Fig. 1 schematically shows an exemplary schematic diagram of a Doherty amplifier in the related art;
Fig. 2 schematically shows an exemplary schematic diagram of an output network for a Doherty amplifier according to some embodiments of the present disclosure;
Fig. 3 schematically shows an exemplary schematic diagram of the output network of Fig. 2 according to some embodiments of the present disclosure, illustrating load modulation at low power;
Fig. 4 schematically shows an exemplary schematic diagram of the output network of Fig. 2 according to some embodiments of the present disclosure, illustrating load modulation at high power;
Fig. 5 schematically shows an exemplary circuit topology of a first sub-network and a main output network according to some embodiments of the present disclosure;
Fig. 6 schematically shows an exemplary circuit topology diagram of a second sub-network according to some embodiments of the present disclosure;
Fig. 7 schematically shows an exemplary circuit topology diagram of a merging matching network according to some embodiments of the present disclosure;
Fig. 8 schematically shows an exemplary schematic diagram of a Doherty amplifier according to some embodiments of the present disclosure;
Fig. 9 schematically shows a schematic diagram of a package structure comprised by the Doherty amplifier according to some embodiments of the present disclosure;
Fig. 10 schematically shows a schematic diagram of a package structure comprised by the Doherty amplifier according to other embodiments of the present disclosure;
Fig. 11 schematically shows a schematic diagram of a package structure comprised by the Doherty amplifier according to another embodiment of the present disclosure;
Fig. 12 schematically shows a schematic diagram of various implementations of an inductor according to some embodiments of the present disclosure;
Fig. 13 schematically shows a structural diagram of the Doherty amplifier according to some embodiments of the present disclosure;
Fig. 14 schematically shows a flowchart of a design method of the Doherty amplifier according to some embodiments of the present disclosure;
Fig. 15 schematically shows a performance example diagram of the Doherty amplifier according to some embodiments of the present disclosure; and
Fig. 16 schematically shows a performance example diagram of the Doherty amplifier according to some embodiments of the present disclosure.

### DETAILED DESCRIPTION OF THE EMBODIMENTS

Some embodiments of the present disclosure will be described in more detail below with reference to the drawings in order to enable one skilled in the art to implement the technical proposal of the present disclosure. The technical proposals of the present disclosure can be embodied in many different forms and purposes and should not be limited to the embodiments described herein. These embodiments are provided in order to make the technical proposal of the present disclosure clear and complete, but the embodiments do not limit the scope of protection of the present disclosure.

Unless otherwise defined, all terms (comprising technical terms and scientific terms) used herein have the same meanings as those normally understood by those of ordinary skill in the field to which the application relates. It will be further understood that terms such as those defined in commonly used dictionaries should be interpreted as having meanings consistent with their meanings in the relevant field and/or in the context of this specification, and will not be interpreted in an idealized or overly formal sense unless expressly defined herein.

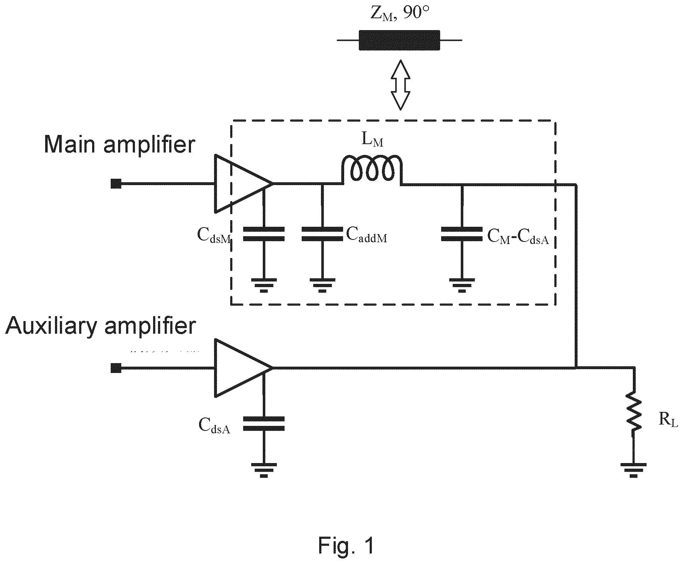

Fig. 1 schematically shows an exemplary schematic diagram of a Doherty amplifier in the related art. As shown in Fig. 1, the Doherty amplifier comprises two amplifiers (a main amplifier and an auxiliary amplifier), the main amplifier and the auxiliary amplifier are respectively connected to two output ports of the power divider (not shown), and the radio frequency output ports of the main amplifier and the auxiliary amplifier are connected to a power combination network composed of capacitors and inductors, where C_{dsM} and C_{dsA} are respectively the parasitic capacitors of the transistors corresponding to the main amplifier and the auxiliary amplifier, C_{addM} and C_{M}-C_{dsA} are lumped capacitive elements, and L_{M} is lumped inductive elements. The two-port network formed by these capacitors and inductors can be equivalent to a transmission line (that is, a quarter-wavelength transmission line) with a characteristic impedance of Z_{M} and an electrical length of 90°. in the operating frequency band. In related arts, the main amplifier works in Class B or Class AB, and the auxiliary amplifier works in Class C. As the input power increases, the current output after the auxiliary amplifier is turned on will modulate the load R_{L}, and then dynamically modulate the two respective loads of the amplifiers (this process is also called "dynamic load modulation"). The two amplifiers do not work in turn, but the main amplifier works all the time, and the auxiliary amplifier starts to work when the input power reaches a set peak. The quarter-wavelength transmission line in the output path of the main amplifier can play the role of phase compensation, so that the output signal in the output path of the main amplifier and the output signal in the output path of the auxiliary amplifier have the same phase at the combination joint.

With the continuous development of communication technology, multiple-input multiple-output (MIMO) systems are more and more widely used. The radio frequency front-end system of MIMO systems comprises multiple (for example, dozens or even hundreds) radio frequency link units, which puts forward higher and higher requirements for the miniaturized design of power amplifiers in radio frequency link units. However, the conventional proposal makes it difficult to meet the design requirements of miniaturized amplifiers due to high complexity, many components, and large circuit size.

On the other hand, the increase of circuit components brings more problems to the integrated design of power amplifiers, not only does the design difficulty increase, the overall circuit size increases, and the chip cost increases, but the circuit loss becomes larger, and the efficiency of power amplifiers will also decrease, which makes it more difficult to design a high-efficiency, energy-saving, and low-cost system.

In addition, with the continuous iteration of the communication system, the communication bandwidth is increasing exponentially. Exemplarily, in the 5G scenario, the communication bandwidth has reached 500MHz or even higher, which poses a high challenge to the operating bandwidth of the power amplifier. In Fig. 1, the load modulation of the Doherty amplifier is realized by a quarter-wavelength transmission line which has only a narrow operating bandwidth (often less than 200 MHz), so this architecture is far from meeting the requirements of today's system broadband operation.

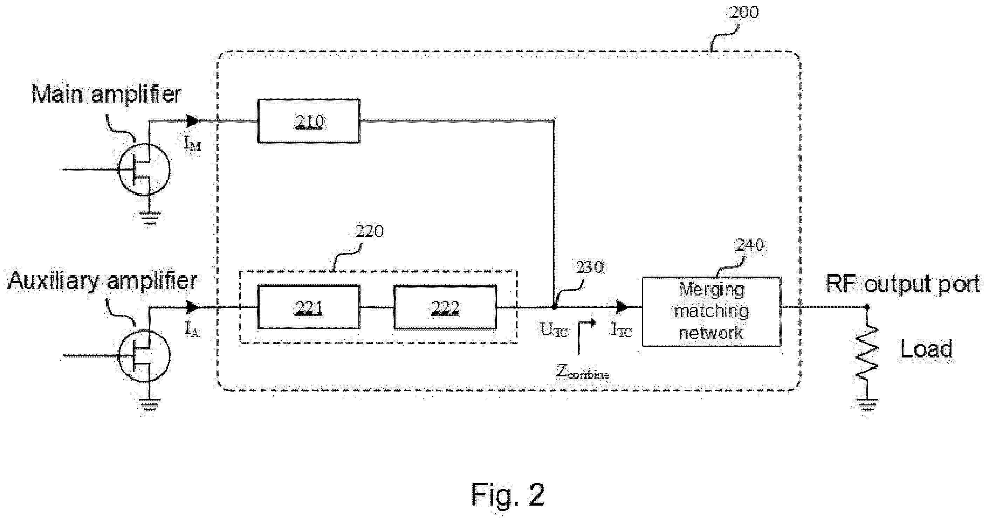

Fig. 2 schematically shows an exemplary schematic diagram of an output network 200 for a Doherty amplifier according to some embodiments of the present disclosure. As shown in Fig. 2, the output network 200 comprises a combination node 230, a main output network 210 connected between an output port of the main amplifier of the Doherty amplifier and the combination node 230, an auxiliary output network 220 connected between an output port of the auxiliary amplifier of the Doherty amplifier and the combination node 230, and a merging matching network 240 connected between the combination node 230 and a radio frequency output port of the Doherty amplifier.

Exemplarily, the auxiliary output network 220 comprises a first sub-network 221 and a second sub-network 222 connected in series, the first sub-network 221 and the main output network 210 having the same circuit topology and each at least comprising an inductor and a capacitor, and the second sub-network 222 at least comprising an inductor, where the merging matching network 240 is configured for the node impedance at the combination node 230 being a complex impedance Z_{combine}, and the main output network 210 and the auxiliary output network 220 are configured for the node impedance matching with the goal load impedances of the main amplifier and the auxiliary amplifier. Exemplarily, the second sub-network 222 can comprise only one inductor, one end of the inductor is connected to the output port of the first sub-network 221, and the other end of the inductor is connected to the combination node 230. Alternatively, the second sub-network 222 can comprise an inductor and a capacitor (e.g., a LC circuit).

**As** shown in Fig. 2, Z_{combine} is the equivalent impedance viewed from the combination node 230 toward the merging matching network 240, and in some cases can be considered as the ratio of the voltage U_{TC} at the combination node 230 to the current I_{TC} flowing into the merging matching network 240. The merging matching network 240 can comprise an appropriate type and number of circuit components, so long as these circuit components make the node impedance at the combing node 230 a complex impedance Z_{combine}. Exemplarily, the merging matching network 240 can comprise an LC circuit, and causes the load (e.g., R_{L} in Fig. 1) at the radio frequency output port of the Doherty amplifier to be converted to a complex impedance Z_{combine}, that is, the node impedance at the combination node 230 is a complex impedance Z_{combine}.

It should be noted that in the present disclosure, the expression "A and B have the same circuit topology" indicates that A and B comprise the same type and the same number of circuit elements (devices or components), and that the connection relationship between these circuit elements in A and B is also the same. Exemplarily, the first sub-network 221 and the main output network 210 having the same circuit topology may both comprise an LC circuit or an LLC circuit. In addition, although the first sub-network 221 and the main output network 210 have the same circuit topology, this does not mean that the element parameters of the first sub-network 221 and the main output network 210 are also the same. For example, they can each comprise an LC circuit, but the corresponding inductance and capacitance values in the LC circuit can be different.

In the embodiment shown in Fig. 2, the first sub-network 221 and the second sub-network 222 form the auxiliary output network 220, but this does not exclude the case where the auxiliary output network 220 comprises other elements (the same for the main output network 210). Exemplarily, in other embodiments, the main output network 210 can further comprise other circuit devices, such as capacitors for isolating direct current (DC). Likewise, the auxiliary output network 220 can further comprise other circuit devices, such as capacitors for isolating DC. Alternatively or additionally, the auxiliary output network 220 can further comprise other sub-networks, such as one or more third sub-networks (circuit topology thereof can be the same as the second sub-network 222).

In addition, the combination node 230 indicates a common connection point of the main output network 210, the auxiliary output network 220, and the merging matching network 240. Exemplarily, the combination node 230 can be a common electrical contact of the main output network 210, the auxiliary output network 220, and the merging matching network 240, the combination node 230 can also be an electrical node of the output port of the main output network 210, the combination node 230 can also be an electrical node of the output port of the auxiliary output network 220, and even the combination node 230 can be an electrical node of the input port of the merging matching network 240.

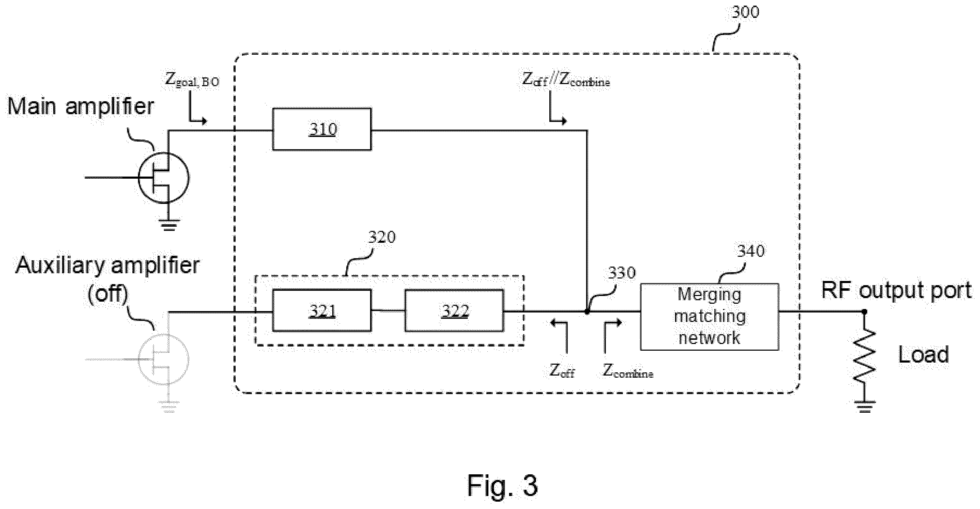

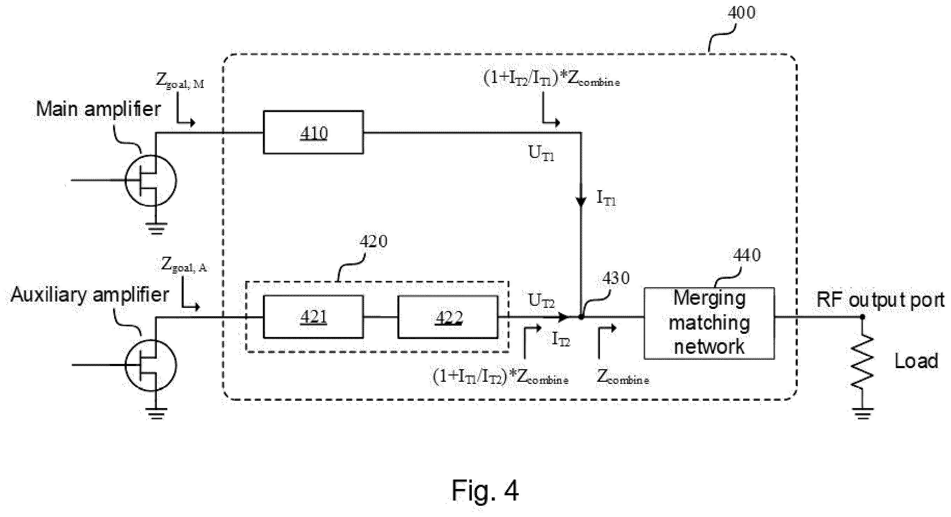

Specifically, the impedance matching process of the output network 200 will be illustrated below with reference to Figs. 3 and 4.

As shown in Fig. 3, at low power, the auxiliary amplifier is not turned on, so it can be equivalent to an off state. At this time, the branch of the auxiliary output network 320 (hereinafter referred to as the auxiliary path) provides the auxiliary path impedance Z_{off} at the combination node 330, and is connected in parallel with the node impedance Z_{combine} at one end of the branch of the main output network 310 (hereinafter referred to as the main path). At the back-off power, the main output network 310 can convert the parallel impedance Z_{off}//Z_{combine} of the auxiliary impedance Z_{off} and the node impedance Z_{combine} to the goal load impedance of the main amplifier at the back-off power (Z_{goal, BO} in Fig. 3). For a main or auxiliary amplifier (typically implemented as a transistor), the goal load impedance indicates the optimal power-matched impedance of the amplifier at a particular power level, that is, the load impedance capable of maximizing the efficiency of the amplifier at a particular power level. The goal load impedance depends on the parameters of the amplifier and the actual power level. It can be obtained by theoretical calculation or simulation analysis, and can also be obtained by experimental methods (such as load traction test). The main output network 310 converts the parallel impedance Z_{off}//Z_{combine} to the goal load impedance Z_{goal, BO} of the main amplifier at the back-off power, so that the main amplifier can still operate efficiently at the back-off power.

As shown in Fig. 4, when the auxiliary amplifier is turned on at high power, the current flowing through the auxiliary path is I_{T2}, and the current flowing through the main path is I_{T1}. According to Kirchhoff's voltage law and Kirchhoff's current law, it can be obtained that at this time the combined equivalent impedance of the main path is (1+I_{T2}/I_{T1})*Z_{combine}, and the combined equivalent impedance of the auxiliary path is (1+I_{T1}/I_{T2})*Z_{combine}, so the current I_{T2} can dynamically modulate the combined equivalent impedance of the main path and the combined equivalent impedance of the auxiliary path. At saturated power, the main output network 410 can convert the combined equivalent impedance (1+I_{T2}/I_{T1})*Z_{combine} of the main path to the goal load impedance of the main amplifier at saturated power (Z_{goal, M} in Fig. 4). The auxiliary output network 420 (comprising the first sub-network 421 and the second sub-network 422) can convert the combined equivalent impedance 1+I_{T1}/I_{T2})*Z_{combine} of the auxiliary path into the goal load impedance of the auxiliary amplifier at saturated power (Z_{goal, A} in Fig. 4). The main output network 410 and the auxiliary output network 420 can make the main amplifier and the auxiliary amplifier operate efficiently and respectively at saturated power by converting the combined equivalent impedance of the main path and the combined equivalent impedance of the auxiliary path into the corresponding goal load impedances of the main amplifier and the auxiliary amplifier at saturated power.

The "combined equivalent impedance" referred to herein indicates the equivalent impedance viewed from a combination node (i.e., combination node 430) on a path. Exemplarily, as shown in Fig. 4, the combined equivalent impedance of the main path is the ratio of the main path output port voltage U_{T1} to the main path output current I_{T1}, and the combined equivalent impedance of the auxiliary path is the ratio of the auxiliary path output port voltage U_{T2} to the auxiliary path output current I_{T2}.

In the present disclosure, the main and auxiliary amplifiers can comprise and are not limited to, for example, VDMOS, LDMOS, or GaN-based power transistors, with different transistor technologies providing different performance advantages in terms of output power, gain, and performance. Exemplarily, the type of transistor can be selected according to the requirements of frequency, bandwidth, cost, etc. According to some embodiments of the present disclosure, the main amplifier and the auxiliary amplifier can be the same type of power transistor (such as a GaN-based power transistor), and the parameter and the size of the transistor serving as the main amplifier and the transistor serving as the auxiliary amplifier can be exactly the same. In other embodiments, transistors serving as main amplifiers and transistors serving as auxiliary amplifiers differ in at least one aspect of transistor type, parameters, size, and the like. According to other embodiments of the present disclosure, the main amplifier or the auxiliary amplifier can comprise a plurality of transistors. There are no specific limitations on the specific embodiments of the main amplifier and the auxiliary amplifier herein.

By using the output network 200 shown in Fig. 2 in the Doherty amplifier, the node impedance Z_{combine} at the combination node 230 can be matched to the goal load impedances of the main amplifier and the auxiliary amplifier of the Doherty amplifier at different power levels, so that the main amplifier can still operate efficiently at the back-off power, and both the main amplifier and the auxiliary amplifier can operate efficiently at the saturation power, that is, the Doherty amplifier can operate efficiently at different power levels. On the other hand, the first sub-network 221 and the main output network 210 have the same circuit topology and each at least comprises an inductor and a capacitor, and the second sub-network 222 at least comprises an inductor, thereby conducive to simplifying the structure of the output network of the Doherty amplifier and the corresponding design process. In addition, as will be further described below, by reasonably setting the circuit topology and component parameters of each sub-network in the main output network 210 and the auxiliary output network 220, the Doherty amplifier can operate with high efficiency while having a larger operating bandwidth and a deeper back-off power (that is, a larger back-off power range).

In some embodiments, the main output network can be equivalent to the first transmission line TL₁ in the operating frequency band, the auxiliary output network can be equivalent to the second transmission line TL₂ in the operating frequency band, and the electrical angle θ_{M} of the first transmission line TL₁ and the electrical angle θ_{A} of the second transmission line TL₂ satisfy 70°<θ_{M}<90°, and 135°<θ_{A}<180°. The above range can be achieved by appropriately selecting the circuit topology and element parameters of the main output network and the auxiliary output network. Taking the output network 200 shown in Fig. 2 as an example, in particular, by selecting the circuit topology and element parameters of the main output network 210, the first sub-network 221, and the second sub-network 222, the transmission lines (the first transmission line TL₁ and the second transmission line TL₂) that are equivalent to the main output network 210 and the auxiliary output network 220 in the operating frequency band can have corresponding characteristic impedances and electrical lengths, and the electrical angle θ_{M} of the first transmission line TL₁ and the electrical angle θ_{A} of the second transmission line TL₂ satisfy the above range. The above range is conducive to enabling the Doherty amplifier to operate at high efficiency while having a larger operating bandwidth and a deeper back-off power.

In some embodiments, the output network can be configured for the output current I_{M} of the main amplifier and the output current I_{A} of the auxiliary amplifier to ensure that the amplitude of the I_{M} is not larger than the amplitude of the I_{A}, and the phase difference between the I_{M} and I_{A} is less than 90°, that is, the phase of the I_{A} minus the phase of the I_{M} results in less than 90°. Similar to the above, the above constraints on IM and IA can be achieved by appropriately selecting the circuit topology and component parameters of the main output network and the auxiliary output network, which is conducive to enabling the Doherty amplifier to operate at high efficiency while having a larger operating bandwidth and a deeper back-off power.

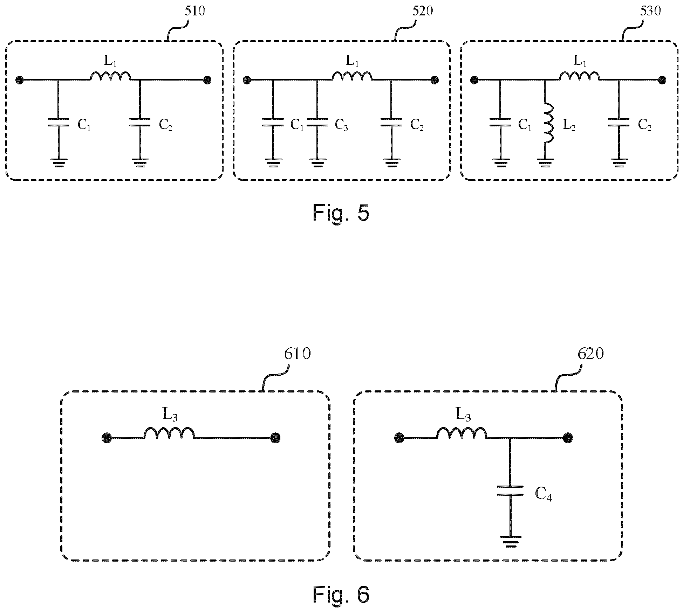

Fig. 5 schematically shows an exemplary circuit topology of a first sub-network and a main output network according to some embodiments of the present disclosure.

As shown in Fig. 5, in some embodiments, the first sub-network and the main output network can have a circuit topology 510, and each comprises a first capacitor C₁, a second capacitor C₂, and a first inductor L₁, one end of the first capacitor C₁ and one end of the first inductor L₁ are connected to the output port of the main amplifier or the auxiliary amplifier (i.e., one end of the first capacitor C₁ and one end of the first inductor L₁ in the main output network are connected to the output port of the main amplifier, and one end of the first capacitor C₁ and one end of the first inductor L₁ in the first sub-network are connected to the output port of the auxiliary amplifier), the other end of the first capacitor C₁ is grounded, the other end of the first inductor L₁ is connected to one end of the second capacitor C₂, and the other end of the second capacitor C₂ is grounded.

In some embodiments, the first sub-network and the main output network can have a circuit topology 520, relative to the circuit topology 510, and each further comprises a third capacitor C₃. One end of the third capacitor C₃ is connected to the output port of the main amplifier or the auxiliary amplifier (i.e., one end of the third capacitor C3 in the main output network is connected to the output port of the main amplifier, and one end of the third capacitor C3 in the first sub-network is connected to the output port of the auxiliary amplifier), and the other end of the third capacitor C₃ is grounded.

In some embodiments, the first sub-network and the main output network can have a circuit topology 530, relative to the circuit topology 510, and each further comprises a second inductor L₂. One end of the second inductor L₂ is connected to the output port of the main amplifier or the auxiliary amplifier (i.e., one end of the second inductor L₂ in the main output network is connected to the output port of the main amplifier, and one end of the second inductor L₂ in the first sub-network is connected to the output port of the auxiliary amplifier), and the other end of the second inductor L₂ is grounded.

Fig. 6 schematically shows an exemplary circuit topology diagram of the second sub-network according to some embodiments of the present disclosure. As shown in Fig. 6, in some embodiments, the second sub-network can have a circuit topology 610, that is, the second sub-network comprises a third inductor L₃. One end of the third inductor L₃ is connected to the output port of the first sub-network, and the other end of the third inductor L₃ is connected to the combination node. In other embodiments, the second sub-network can have a circuit topology 620, relative to the circuit topology 610, and the second sub-network further comprises a fourth capacitor C₄. As shown in the circuit topology 620, one end of the third inductor L₃ is connected to the output port of the first sub-network, the other end of the third inductor L₃ is connected to one end of the fourth capacitor C₄ (the other end of the third inductor L₃ is also connected to the combination node), and the other end of the fourth capacitor C₄ is grounded.

It is to be noted that although the circuit topology 620 of the second sub-network shown in Fig. 6 comprises an LC circuit comprising a third inductor L₃ and a fourth capacitor C₄. One skilled in the art will understand that the second sub-network can further comprise other circuit devices, such as capacitors for isolating DC. Similarly, although not shown in the respective circuit topologies of Fig. 5, one skilled in the art will appreciate that at least one of the circuit topologies 510, 520, and 530 shown in Fig. 5 can comprise other circuit devices, such as capacitors for isolating DC.

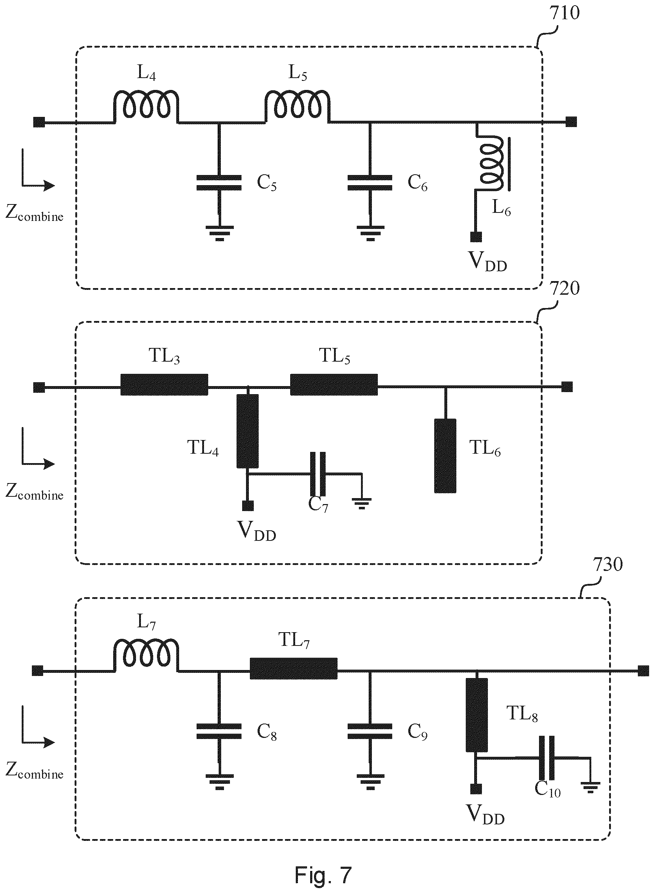

Fig. 7 schematically shows an exemplary circuit topology diagram of the merging matching network according to some embodiments of the present disclosure.

As shown in Fig. 7, in some embodiments, the merging matching network can have a circuit topology 710, and the merging matching network comprises a fourth inductor L₄, a fifth inductor L₅, a sixth inductor L₆, a fifth capacitor C₅, and a sixth capacitor C₆. One end of the fourth inductor L₄ is connected to the combination node, the other end of the fourth inductor L₄ is connected to one end of the fifth capacitor C₅ and one end of the fifth inductor L₅, and the other end of the fifth capacitor C₅ is grounded. The other end of the fifth inductor L₅ is connected to one end of the sixth capacitor C₆ and one end of the sixth inductor L₆, the other end of the sixth capacitor C₆ is grounded. The other end of the sixth inductor L₆ is connected to a DC voltage port, the DC voltage port is configured to provide the main amplifier and the auxiliary amplifier via the sixth inductor L₆, the fifth inductor L₅, the fourth inductor L₄, the main output network and the auxiliary output network.

In some embodiments, the merging matching network can have a circuit topology 720, that is, the merging matching network comprises a third transmission line TL₃, a fourth transmission line TL₄, a fifth transmission line TL₅, a sixth transmission line TL₆. One end of the third transmission line TL₃ is connected to one end of the fourth transmission line TL₄ and one end of the fifth transmission line TL₅, the other end of the fourth transmission line TL₄ connected to a DC voltage port and one end of the seventh capacitor C₇, the other end of the seventh capacitor C₇ is grounded, the other end of the fifth transmission line TL₅ is connected to one end of the sixth transmission line TL₆, the other end of the sixth transmission line TL₆ is floating, and the DC voltage port is configured to provide the main amplifier and the auxiliary amplifier with a DC bias voltage V_{DD} via the fourth transmission line TL₄, the third transmission line TL₃, the auxiliary output network and the auxiliary output network.

In some embodiments, the merging matching network can have a circuit topology 730, that is, the merging matching network comprises a seventh inductor L₇, an eighth capacitor Cs, a ninth capacitor C₉, a tenth capacitor C₁₀, a seventh transmission line TL₇, and an eighth transmission line TL₈. One end of the seventh inductor L₇ is connected to combination node, the other end of the seventh inductor L₇ is connected to one end of the eighth capacitor C₈ and one end of the seventh transmission line TL₇, the other end of the eighth capacitor C₈ is grounded, the other end of the seventh transmission line TL₇ is connected to one end of the ninth capacitor C₉ and one end of the eighth transmission line TL₈, the other end of the ninth capacitor C₉ is grounded, the other end of the eighth transmission line TL₈ is connected to a DC voltage port, one end of the tenth capacitor C₁₀ is connected to the DC voltage port, the other end of the tenth capacitor C₁₀ is grounded, the DC voltage port is configured to provide the DC bias voltage V_{DD} to the main amplifier and the auxiliary amplifier via the eighth transmission line TL₈, the seventh transmission line TL₇, the seventh inductor L₇, the main output network and the auxiliary output network.

It is to be noted that although not shown in the respective circuit topologies of Fig. 7, one skilled in the art will understand that at least one of the circuit topologies 710, 720, and 730 shown in Fig. 7 can comprise other circuit devices, such as capacitors for isolating DC, with which DC signals from the DC voltage port are not transmitted to the radio frequency output port of the Doherty amplifier, so that sensitive radio frequency elements (loads) can be protected from DC power.

Further, in the embodiments described above with respect to Figs. 5 and 6, although an associated bias circuit providing the DC bias voltage V_{DD} to the main amplifier and the auxiliary amplifier is not disclosed, this is only schematic, and one skilled in the art will understand that the associated bias circuit can be provided in the embodiments according to practical applications. The number of associated bias circuits and the position thereof in the Doherty amplifier circuit can be flexibly adjusted. Exemplarily, when the configuration parameters of the main amplifier and the auxiliary amplifier of the Doherty amplifier are not the same (e.g., when they are not the same type of transistor), corresponding DC bias circuits can be provided for the main amplifier and the auxiliary amplifier respectively. Exemplarily, the corresponding DC bias circuit can be provided in the main output network to provide DC bias for the main amplifier, and the corresponding DC bias circuit can be provided in the first sub-network or the second sub-network to provide DC bias for the auxiliary amplifier. Alternatively, corresponding DC bias circuits can be provided in the merging matching network to provide DC bias for the main and auxiliary amplifiers (for example, the circuit topologies 710, 720, and 730 disclosed above).

According to some embodiments, at least one of the first to the tenth capacitor can be implemented in at least one of a PCB surface mount element and an integrated circuit device.

According to some embodiments, at least one of the first to the seventh inductor can be implemented in at least one of a PCB surface mount element, an integrated circuit device, a bonding wire, a microstrip line, a metal winding wire, and a transmission line.

According to some embodiments, at least one of the third to the eighth transmission line can be implemented in at least one of a microstrip line, a strip line, a coplanar waveguide, and a substrate integrated waveguide.

Microstrip line is a kind of planar transmission line used most in hybrid microwave integrated circuits and monolithic microwave integrated circuits at present. It is a strip conductor (signal line), which is isolated from the ground by a dielectric. Microstrip lines can be realized by PCB microstrip lines and integrated circuit microstrip lines. The factors affecting the characteristic impedance of the microstrip line comprise the thickness, the width, the distance between the microstrip line and the ground and the dielectric constant of the dielectric etc. The length of the microstrip line can correspond to the electrical angle of the microstrip line. Exemplarily, at least one of the third to the eighth transmission lines can be implemented with a microstrip line. Accordingly, the size parameters such as length, width, and the like of the microstrip line can be configured based on characteristic impedances and electrical angles of the respective transmission lines of the third to the eighth transmission line. By using a microstrip line to implement the corresponding transmission lines of the third to the eighth transmission line, it is possible to obtain transmission lines that meet the requirements of characteristic parameters, so that the Doherty amplifier can have a smaller circuit size, higher operating efficiency, larger operating bandwidth, and deeper back-off power (i.e., a larger back-off power range). In particular, the microstrip line can be realized by selecting a substrate with a high dielectric constant to further reduce the size of the associated circuit.

Strip line is a high-frequency transmission line between dielectrics placed between two parallel ground planes (or power supply planes). Strip line has the advantages of small size, light weight, wide bandwidth, high-quality factor, simple process, low cost, etc. It is adapted for making high performance (wide frequency band, high quality factor, high isolation) passive components. Coplanar waveguide (CPW) is constructed by fabricating a central conductor strip on one surface of the dielectric substrate and fabricating a conductor plane on both sides of the central conductor strip. In the millimeter wave band, CPW has lower losses than the microstrip line and strip line. Substrate integrated waveguide (SIW) uses metal through-holes to realize the field propagation mode of the waveguide on the dielectric substrate, which has the advantages of low differential loss, low radiation, and high-quality factor. In some embodiments, at least one of the third to the eighth transmission line can comprise only one of a strip line, a coplanar waveguide, or a substrate integrated waveguide.

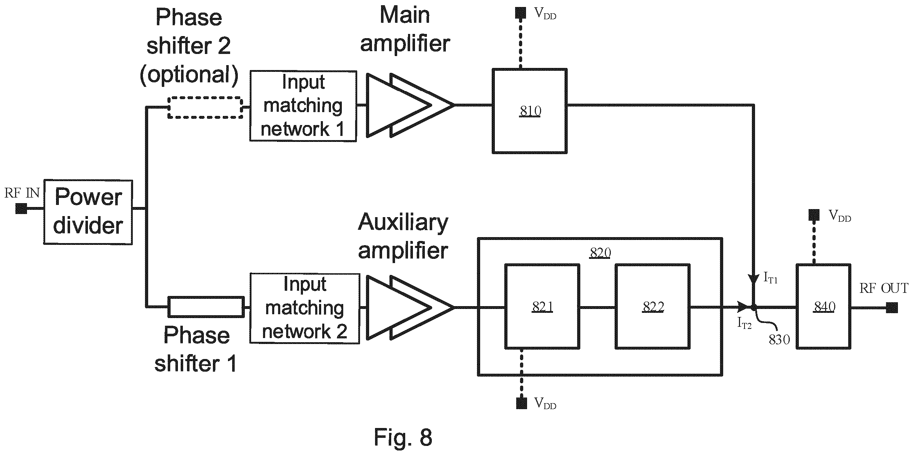

Another embodiment of the present disclosure provides a Doherty amplifier comprising: a main amplifier; an auxiliary amplifier; and an output network according to any of the above embodiments, where the output network is configured to receive a first amplified signal outputted by the main amplifier and a second amplified signal outputted by the auxiliary amplifier, and the first amplified signal and the second amplified signal are combined at the combination node to be provided to a radio frequency output port of the Doherty amplifier. Since the Doherty amplifier comprises the output network according to the aforementioned embodiment of the present disclosure, the Doherty amplifier has the advantages of the corresponding output network. The Doherty amplifier is described further below with reference to Fig. 8.

As shown in Fig. 8, the radio frequency input signal after passing through the power divider is respectively connected to the main amplifier and the auxiliary amplifier (the amplifiers can be single-stage transistors or multi-stage transistors cascaded), where the input side of the main amplifier and the auxiliary amplifier further comprises an input matching network (that is, the input matching network 1 and the input matching network 2 shown in Fig. 8) and a phase shifter network (that is, the phase shifter 1 and the phase shifter 2 shown in Fig. 8), where the phase shifter network can be provided only in the auxiliary path or only in the main path (for example, only in the auxiliary path). The output side of the main amplifier and the auxiliary amplifier is the output network according to any one of the above embodiments of the present disclosure, the output network comprises a main output network 810 and an auxiliary output network 820, and the auxiliary output network 820 comprises a first sub-network 821 and a second sub-network 822 connected in series. The merging matching network 840 is configured for the node impedance at the combination node 830 being a complex impedance, and the main output network 810 and the auxiliary output network 820 are configured for the node impedance matching with the goal load impedances of the main amplifier and the auxiliary amplifier. Exemplarily, the (drain) DC bias voltage can be electrically fed through the DC bias circuit in the main output network 810 and the first sub-network 821 (or merging matching network 840).

The main output network 810 and the first sub-network 821 can have any one of the circuit topologies described above with respect to Fig. 5, the second sub-network 822 can have the circuit topology described above with respect to Fig. 6, and the merging matching network 840 can have any one of the circuit topologies described above with respect to Fig. 7. By selecting the circuit topology and component parameters of the main output network 810, the first sub-network 821, and the second sub-network 822, the transmission lines equivalent to the main output network 810 and the auxiliary output network 820 in the operating frequency band can have corresponding characteristic impedance, electrical length, and electrical angle, so that the Doherty amplifier can operate with high efficiency while having a large operating bandwidth and a deep back-off power.

It should be noted that although the Doherty amplifier shown in Fig. 8 comprises only one auxiliary amplifier, one skilled in the art will understand that the Doherty amplifier disclosed in the present disclosure can comprise more auxiliary amplifiers (e.g., two auxiliary amplifiers), and on the basis of the above embodiments of the present disclosure, a plurality of auxiliary output networks on a plurality of auxiliary paths corresponding to these auxiliary amplifiers can adopt the circuit structure disclosed in the above embodiments of the present disclosure.

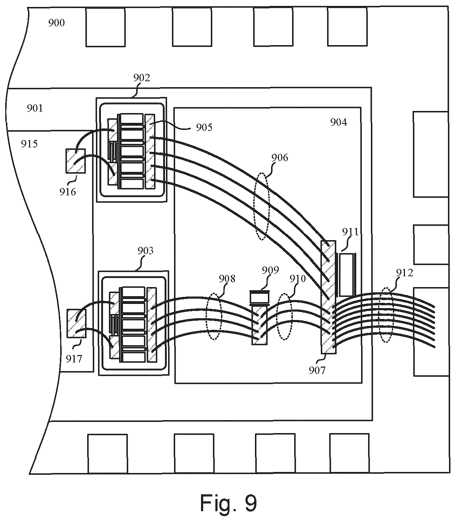

Fig. 9 schematically shows a schematic diagram of a package structure comprised of the Doherty amplifier according to some embodiments of the present disclosure. As shown in Fig. 9, the Doherty amplifier comprises a package carrier 900 (which can be in an LGA structure or a QFN structure). The package carrier 900 comprises a metal pad 901 (the main purpose is to carry circuit elements and provide heat dissipation and grounded circuits); a main amplifier circuit chip 902, having an output port connected to the pad 907 via a set of bonding wires 906 (the parasitic equivalent inductance thereof can be controlled by adjusting the number, spacing, height, and length of the bonding wires); an auxiliary amplifier circuit chip 903, similar to the main amplifier circuit chip 902, having an output end also connected to the pad via a set of bonding wires 908; and an output matching unit chip 904. The circuit topology of the main output network and the first sub-network is similar to the circuit topology 510 described above with respect to Fig. 5 (but excluding the first capacitor C₁), and the second sub-network adopts the circuit topology 600 described above with respect to Fig. 6. The bonding wire 906 is employed to implement the first inductor L₁ in the main output network. As can be seen from Fig. 9, since parasitic capacitors C_{dsM} and C_{dsA} (i.e., the first capacitor C₁) are not required, the output ports of the main amplifier circuit chip 902 and the auxiliary amplifier circuit chip 903 can be directly connected to the bonding wires 906, 908. The bonding wires 908, 910 are respectively employed to implement the first inductor L₁ in the first sub-network and the third inductor L₃ in the second sub-network (L₁ can be equal to L₃). The capacitor 909 is employed to implement the second capacitor C₂ in the first sub-network, and the capacitor 911 is employed to implement the second capacitor C₂ in the main output network and the fourth capacitor C₄ in the second sub-network, i.e., the capacitor 911 can be regarded as a parallel capacitor (C₂+C₄) of the second capacitor C₂ in the main output network and the fourth capacitor C₄ in the second sub-network. The output matching unit chip 904 is connected to the package output pin via a bonding wire 912. In addition, the input ports of the main amplifier circuit chip 902 and the auxiliary amplifier circuit chip 903 are electrically connected to the pads 916 and 917 on the input circuit chip 915 via a bonding wire or the like, and the pads 916 and 917 are connected to the input matching circuit. The present disclosure does not limit the specific implementation form of the input matching circuit.

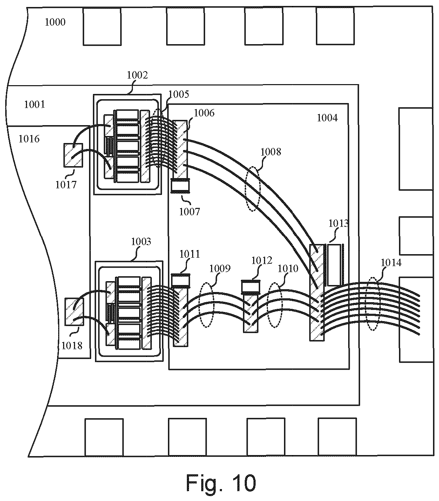

Fig. 10 schematically shows a schematic diagram of the package structure comprised of the Doherty amplifier according to other embodiments of the present disclosure. As shown in Fig. 10, the Doherty amplifier comprises a package carrier 1000 (which can be in an LGA structure or a QFN structure). The package carrier 1000 comprises a metal pad 1001 (the main purpose is to carry circuit elements and provide heat dissipation and ground circuits); a main amplifier circuit chip 1002, having an output port connected to the pad 1006 via a set of bonding wires 1005, where the height and the length of the bonding wires 1005 are controlled as small as possible, so that the parasitic inductance characteristics thereof are negligible; an auxiliary amplifier circuit chip 1003, similar to the main amplifier circuit chip 1002, having an output port is connected to the pad via a set of bonding wires; an output matching unit chip 1004, where the main output network and the first sub-network employ the circuit topology 520 described above with respect to Fig. 5, and the second sub-network employ the circuit topology 600 described above with respect to Fig. 6. The first capacitor C₁ in the main output network and the first sub-network can be the parasitic capacitors C_{dsM} and C_{dsA} of the transistors in the main amplifier circuit chip 1002 and the sub-amplifier circuit chip 1003 respectively. The capacitor 1007 is employed to implement the third capacitor C₃ in the main output network, and the bonding wire 1008 (the parasitic equivalent inductance can be controlled by adjusting the number, interval, height, and length of the bonding wires) is employed to implement the first inductor L₁ in the main output network, the capacitors 1011, 1012 are respectively employed to implement the third capacitor C₃ and the second capacitor C₂ in the first sub-network, the bonding wires 1009 and 1010 are respectively employed to implement the first inductor L₁ in the first sub-network and the third inductor L₃ in the second sub-network, the capacitor 1013 is employed to implement the second capacitor C₂ in the main output network and the fourth capacitor C₄ in the second sub-network, that is, the capacitor 1013 can be regarded as a parallel capacitor (C₂+C₄) of the second capacitor C₂ in the main output network and the fourth capacitor C₄ in the second sub-network. The output matching unit chip 1004 is connected to the package output pin via the bonding wire 1014. In addition, the input ports of the main amplifier circuit chip 1002 and the auxiliary amplifier circuit chip 1003 are electrically connected to the pads 1017 and 1018 on the input circuit chip 1016 via a bonding wire or the like, and the pads 1017 and 1018 are connected to the input matching circuit. The present disclosure does not limit the specific implementation form of the input matching circuit.

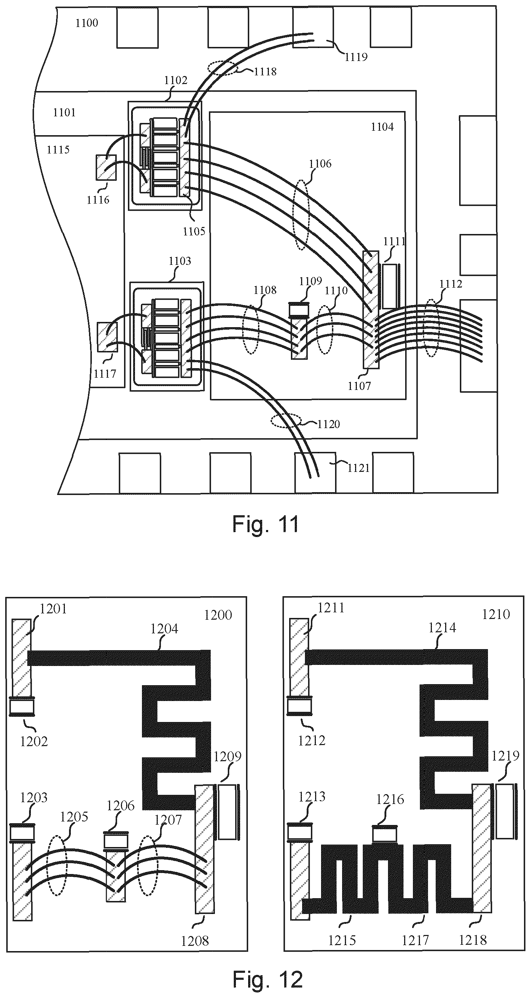

Fig. 11 schematically shows a schematic diagram of the package structure comprised of the Doherty amplifier according to yet another embodiment of the present disclosure. As shown in Fig. 11, the Doherty amplifier comprises a package carrier 1100 (which can be in an LGA structure or a QFN structure). The package carrier 1100 comprises a metal pad 1101 (the main purpose is to carry circuit elements and provide heat dissipation and grounded circuits); a main amplifier circuit chip 1102, having an output port connected to the pad 1107 via a set of bonding wires 1106 (the parasitic equivalent inductance thereof can be controlled by adjusting the number, spacing, height, and length of the bonding wires); an auxiliary amplifier circuit chip 1103, similar to the main amplifier circuit chip 1102, having an output end also connected to the pad via a set of bonding wires 1108; and an output matching unit chip 1104. The circuit topology of the main output network and the first sub-network is similar to the circuit topology 530 described above with respect to Fig. 5 (but excluding the first capacitor C₁), and the second sub-network adopts the circuit topology 600 described above with respect to Fig. 6. The bonding wire 1106 is employed to implement the first inductor L₁ in the main output network. As can be seen from Fig. 11, since parasitic capacitors C_{dsM} and C_{dsA} (i.e., the first capacitor C₁) are not required, the output ports of the main amplifier circuit chip 1102 and the auxiliary amplifier circuit chip 1103 can be directly connected to the bonding wires 1106, 1108. The bonding wires 1108, 1110 are respectively employed to implement the first inductor L₁ in the first sub-network and the third inductor L₃ in the second sub-network (L₁ can be equal to L₃). The capacitor 1109 is employed to implement the second capacitor C₂ in the first sub-network, and the capacitor 1111 is employed to implement the second capacitor C₂ in the main output network and the fourth capacitor C₄ in the second sub-network, i.e., the capacitor 1111 can be regarded as a parallel capacitor (C₂+C₄) of the second capacitor C₂ in the main output network and the fourth capacitor C₄ in the second sub-network. The output matching unit chip 1104 is connected to the package output pin via a bonding wire 1112. In addition, the input ports of the main amplifier circuit chip 1102 and the auxiliary amplifier circuit chip 1103 are electrically connected to the pads 1116 and 1117 on the input circuit chip 1115 via a bonding wire or the like, and the pads 1116 and 1117 are connected to the input matching circuit. The present disclosure does not limit the specific implementation form of the input matching circuit.

Further, as shown in Fig. 11, the output port of the main amplifier circuit chip 1102 is also connected to the package pin 1119 via the bonding wire 1118, and the output port of the auxiliary amplifier circuit chip 1103 is connected to the package pin 1121 via the bonding wire 1120. By adjusting the number, interval, height, length, etc. of the bonding wires 1118 and 1120, the parasitic equivalent inductance thereof can be controlled to realize the second inductor L₂ in the main output network and the second inductor L₂ in the first sub-network. The package pins 1119 and 1121 can be directly or indirectly connected to the ground via an external circuit.

Fig. 12 schematically shows a schematic diagram of various implementations of the inductor according to some embodiments of the present disclosure. As shown in Fig. 12, in the output matching unit chips 1200 and 1210 (which can be employed to implement any of the output matching unit chips described above with respect to Figs. 9 to 11), the inductor can be implemented in the form of a metal wire or a transmission line in addition to the parasitic inductance of the bonding wire. An example is shown on the left side of Fig. 12 in which the first inductor L₁ in the main output network is implemented by a metal winding 1204 (the first inductor L₁ in the first sub-network and the third inductor L₃ in the second sub-network are still implemented by bonding wires 1205 and 1207), the equivalent inductance of the first inductor L₁ can be adjusted by adjusting the length, line width, and winding manner (e.g., interval and length) of the metal winding. On the right side of Fig. 12, an example is shown in which all inductors (the first inductor L₁ in the main output network, the first inductor L₁ in the first sub-network, and the third inductor L₃ in the second sub-network) are implemented by metal windings (1214, 1215, and 1217).

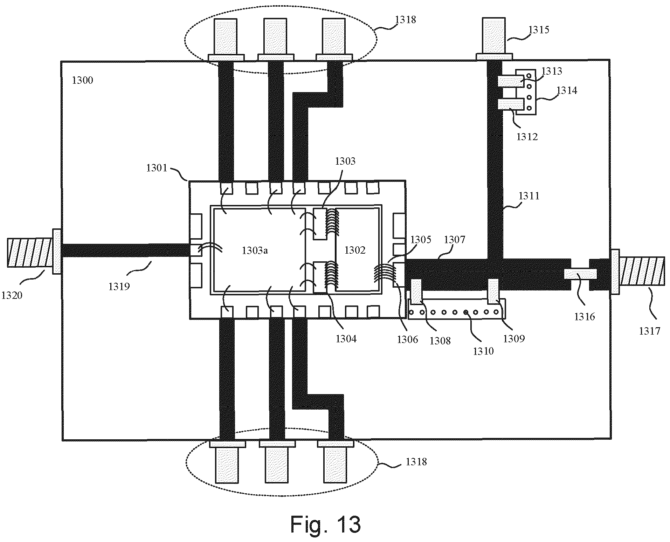

Fig. 13 schematically shows a structural diagram of the Doherty amplifier according to some embodiments of the present disclosure. As shown in Fig. 13, the Doherty amplifier comprises a circuit carrier 1300, and the circuit carrier 1300 comprises a package structure 1301 (which can be any one of the package structures shown in Figs. 9-11) mainly comprising an input circuit 1303a, a transistor amplifier circuit 1303, 1304, and an output circuit 1302 connected to a pin 1306 and to a peripheral PCB circuit to implement the circuit topology 730 described above with respect to Fig. 7 via a bonding wire 1305, where 1305 is the seventh inductor L₇, 1308 is the eighth capacitor C₈, 1307 is the seventh transmission line TL₇, 1309 is the ninth capacitor C₉, the other end of the ninth capacitor C₉ being connected to a pad and connected to ground via a via hole 1310, 1311 is the eighth transmission line TL₈, 1312 is the tenth capacitor C₁₀, 1313 is a filter capacitor, 1316 is a DC-blocking capacitor, 1315 is an external DC voltage port which can provide a drain voltage to the transistor through 1311 (eighth transmission line TL₈) and 1307 (seventh transmission line TL₇), and 1317 is an SMA connector (which provides a radio frequency output port of the Doherty amplifier). An input port 1320 is connected via a transmission line 1319 to a corresponding connector which provides the radio frequency input port of the Doherty amplifier, and a plurality of DC ports referenced with 1318 can provide the required DC bias voltages (e.g., gate voltages and DC voltages of the drive circuit) to the package structure 1301.

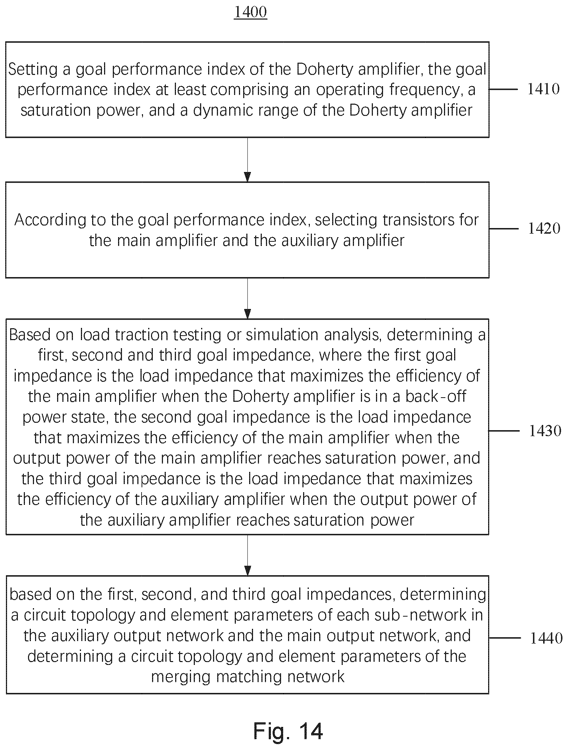

The other embodiments of the present disclosure provide a design method of a Doherty amplifier comprising a main amplifier, an auxiliary amplifier, and an output network 200 described above with respect to Fig. 2. Fig. 14 schematically shows a flow chart 1400 of the design method of the Doherty amplifier in accordance with some embodiments of the present disclosure. As shown in Fig. 14, the method comprises the steps of:

Step 1410, setting a goal performance index of the Doherty amplifier, the goal performance index at least comprising an operating frequency, a saturation power, and a dynamic range of the Doherty amplifier;

Step 1420, according to the goal performance index, selecting transistors for the main amplifier and the auxiliary amplifier. The selecting transistors can take into account various design requirements, such as power, cost, size, etc., and can refer to the above description of different types of transistors, which is not limited in the disclosure;

Step 1430, based on load traction testing or simulation analysis, determining a first, second, and third goal impedance, where the first goal impedance is the load impedance that maximizes the efficiency of the main amplifier when the Doherty amplifier is in a back-off power state, the second goal impedance is the load impedance that maximizes the efficiency of the main amplifier when the output power of the main amplifier reaches saturation power, and the third goal impedance is the load impedance that maximizes the efficiency of the auxiliary amplifier when the output power of the auxiliary amplifier reaches saturation power; and

Step 1440, based on the first, second, and third goal impedances, determining a circuit topology and element parameters of each sub-network in the auxiliary output network and the main output network, and determining a circuit topology and element parameters of the merging matching network.

With the method for designing the Doherty amplifier proposed in the embodiment of the present disclosure, the Doherty amplifier with a more compact structure and a simplified circuit structure and design process can be obtained. In addition, the Doherty amplifier is capable of efficient operation from low power to high power, with a deeper back-off power and a wider operating bandwidth.

An example of the parameter design of the output circuit 1302 shown in Fig. 13 obtained using the above design method is given below (in the output network corresponding to the output circuit 1302, the first sub-network of the main output network and the auxiliary output network using the circuit topology 510 described above with respect to Fig. 5, and the second sub-network of the auxiliary output network using the circuit topology 600 described above with respect to Fig. 6):

The Doherty amplifier corresponding to the output network can be applied in a 5G mobile communication system (3.5 GHz frequency band, 32T transmitter array, base station amplifier), the main amplifier is a transistor based on gallium nitride (GaN) semiconductor technology with the total gate width of 4.8mm, the saturation power of 50W, and the parasitic capacitance C_{dsM} of 2pF (C_{dsM} is the first capacitor in the main output network), the auxiliary amplifier is a transistor based on gallium nitride (GaN) semiconductor technology with the total gate width of 8.4mm, the saturation power of 85W, and the parasitic capacitance C_{dsA} of 3pF (C_{dsA} is the first capacitor in the first sub-network), and other element parameters of each sub-network in the output network 1100 are as follows:
L₁=0.926 nH (L₁ is the first inductor in the main output network);
C_{M}=2.03 pF (C_{M} is the second capacitor in the main output network);
L_{A}=0.358 nH (L_{A} is the first inductor in the first sub-network and the third inductor in the second sub-network);
C₁=5.74 pF (C₁ is the second capacitor in the first sub-network);
C₂=2.87 pF (C₂ is the fourth capacitor in the second sub-network);
Z_{combine}= 2.31-j2.49.

The radio frequency characteristics of the main output network in 3.5GHz band can be equivalent to a transmission line with an electric length of 86°, and the radio frequency characteristics of the auxiliary output network in 3.5GHz band can be equivalent to a transmission line with an electric length of 161°.

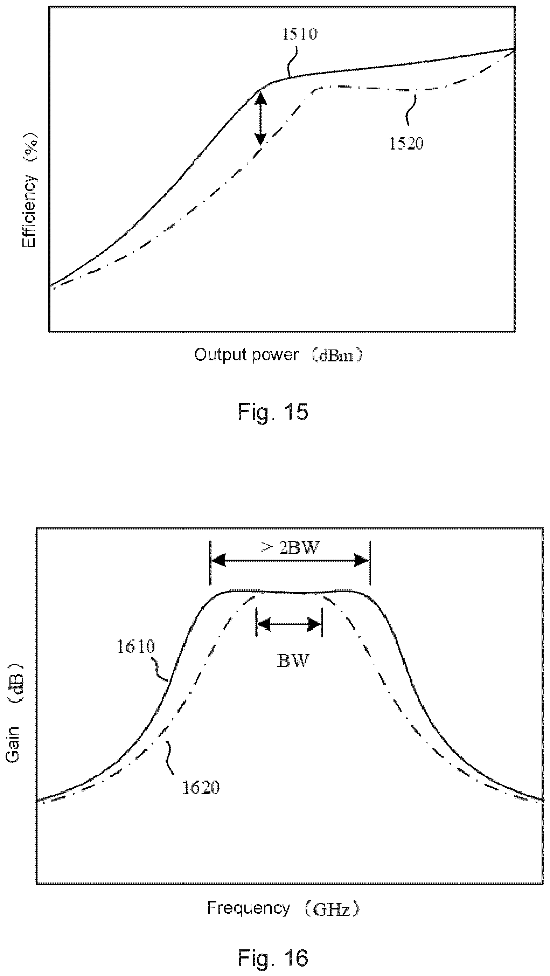

Figs. 15 and 16 schematically show performance example diagrams of a Doherty amplifier according to some embodiments of the present disclosure. As shown in Fig. 15, the amplifier DC-radio frequency conversion efficiency of the Doherty amplifier according to some embodiments of the present disclosure and the conventional Doherty amplifier varies with the output power as shown in curves 1510 and 1520 respectively. It can be seen that the efficiency of the Doherty amplifier according to some embodiments of the present disclosure is much higher than the conventional proposal in the low output power state. As shown in Fig. 16, the amplifier small signal gains of the Doherty amplifiers according to some embodiments of the present disclosure and the conventional Doherty amplifiers are shown in curves 1610, 1620 respectively. It can be seen that the bandwidth of the Doherty amplifiers according to some embodiments of the present disclosure is much larger than that of the conventional Doherty amplifiers (more than twice the bandwidth of the conventional Doherty amplifiers).

It will be appreciated that while the first, second, third and the like terms can be used herein to describe various devices, elements, components or portions, these devices, elements, components or portions should not be limited by these terms. These terms are used only to distinguish one device, element, component or part from another. The "connected" mentioned in the disclosure comprises "direct connected" or "indirect connected".

Although the present disclosure has been described in connection with some embodiments, it is not intended to be limited to the particular form described herein. Rather, the scope of the application is limited by the appended claims only. In addition, although individual features can be comprised in different claims, these can be advantageously combined, and inclusion in the different claims does not imply that a combination of features is not feasible and/or advantageous. The order of the features in the claims does not imply that the features must be in any particular order in which they operate. Further, in the claims, the word "comprise" does not exclude other elements, and the term "a" or "an" does not exclude a plurality. The reference numerals in the claims are provided as explicit examples only and should not be construed as limiting the scope of the claims in any way.

## Claims

1. An output network for a Doherty amplifier, the Doherty amplifier comprising a main amplifier and an auxiliary amplifier, characterized is that:
the output network comprising:
a combination node;
a main output network connected between an output port of the main amplifier and the combination node;
an auxiliary output network connected between an output port of the auxiliary amplifier and the combination node; and
a merging matching network connected between the combination node and a radio frequency output port of the Doherty amplifier;
wherein the auxiliary output network comprises a first sub-network and a second sub-network connected in series, the first sub-network and the main output network having the same circuit topology and each at least comprising an inductor and a capacitor, and the second sub-network at least comprising an inductor;
wherein the merging matching network is configured for the node impedance at the combination node being a complex impedance, and the main output network and the auxiliary output network are configured for the node impedance being matching with the goal load impedances of the main amplifier and the auxiliary amplifier.

2. The output network according to claim 1, wherein the main output network is equivalent to a first transmission line in an operating frequency band, the auxiliary output network is equivalent to a second transmission line in an operating frequency band, and an electrical angle θ_{M} of the first transmission line and the electrical angle θ_{A} of the second transmission line satisfy 70°<θ_{M}<90° and 135°<θ_{A}<180°.

3. The output network according to claim 1, wherein the output network is configured for an output current I_{M} of the main amplifier and an output current I_{A} of the auxiliary amplifier satisfying an amplitude of the I_{M} is not larger than an amplitude of the IA and a phase difference between the I_{M} and the I_{A} is less than 90°.

4. The output network according to claim 1, wherein the first sub-network and the main output network each comprise a first capacitor, a second capacitor, and a first inductor, one end of the first capacitor and one end of the first inductor being connected to the output port of the main amplifier or the auxiliary amplifier, the other end of the first capacitor being grounded, the other end of the first inductor being connected to one end of the second capacitor, and the other end of the second capacitor being grounded.

5. The output network according to claim 4, wherein each of the first sub-network and the main output network further comprises a third capacitor, one end of the third capacitor being connected to the output port of the main amplifier or the auxiliary amplifier, and the other end of the third capacitor being grounded.

6. The output network according to claim 4, wherein each of the first sub-network and the main output network further comprise a second inductor, one end of the second inductor being connected to the output port of the main amplifier or the auxiliary amplifier and the other end of the second inductor being grounded.

7. The output network according to claim 1, wherein the second sub-network comprises a third inductor and a fourth capacitor, one end or the third inductor being connected to an output port of the first sub-network, the other end of the third inductor being connected to one end of the fourth capacitor, the other end of the fourth capacitor being grounded.

8. The output network according to claim 1, wherein the merging matching network comprises a fourth inductor, a fifth inductor, a sixth inductor, a fifth capacitor, and a sixth capacitor, one end of the fourth inductor being connected to the combination node, the other end of the fourth inductor being connected to one end of the fifth capacitor and one end of the fifth inductor, the other end of the fifth capacitor being grounded, the other end of the fifth inductor being connected to one end of the sixth capacitor and one end of the sixth inductor, the other end of the sixth capacitor being grounded, the other end of the sixth inductor being connected to a DC voltage port configured to provide a DC bias voltage to the main amplifier and the auxiliary amplifier via the sixth inductor, the fifth inductor, the fourth inductor, the main output network, and the auxiliary output network.

9. The output network according to claim 1, wherein the merging matching network comprises a third transmission line, a fourth transmission line, a fifth transmission line, a sixth transmission line, and a seventh capacitor, one end of the third transmission line being connected to the combination node, the other end of the third transmission line being connected to one end of the fourth transmission line and one end of the fifth transmission line, the other end of the fourth transmission line being connected to a DC voltage port and one end of the seventh capacitor, the other end of the seventh capacitor being grounded, the other end of the fifth transmission line being connected to one end of the sixth transmission line, the other end of the sixth transmission line being floating, the DC voltage port being configured to provide a DC bias voltage to the main amplifier and the auxiliary amplifier via the fourth transmission line, the third transmission line, the main output network and the auxiliary output network.

10. The output network according to claim 1, wherein the merging matching network comprises a seventh inductor, an eighth capacitor, a ninth capacitor, a tenth capacitor, a seventh transmission line, and an eighth transmission line, one end of the seventh inductor being connected to the combination node, the other end of the seventh inductor being connected to one end of the eighth capacitor and one end of the seventh transmission line, the other end of the eighth capacitor being grounded, the other end of the seventh transmission line being connected to one end of the ninth capacitor and one end of the eighth transmission line, the other end of the ninth capacitor being grounded, the other end of the eighth transmission line being connected to a DC voltage port, one end of the tenth capacitor being connected to the DC voltage port, the other end of the tenth capacitor being grounded, the DC voltage port being configured to provide a DC bias voltage to the main amplifier and the auxiliary amplifier via the eighth transmission line, the seventh transmission line, the seventh inductor, the main output network and the auxiliary output network.

11. The output network according to any one of claims 4 to 10, wherein at least one of the first to the tenth capacitor can be implemented in at least one of a PCB surface mount element and an integrated circuit device.

12. The output network according to any one of claims 4, 6, 7, 8, or 10, wherein at least one of the first to the seventh inductor can be implemented in at least one of a PCB surface mount element, an integrated circuit device, a bonding wire, a microstrip line, a metal winding wire, a transmission line.

13. The output network according to claim 9 or 10, wherein at least one of the third to the eighth transmission line can be implemented in at least one of a microstrip line, a strip line, a coplanar waveguide, a substrate integrated waveguide.

14. A Doherty amplifier, comprising:
a main amplifier;
an auxiliary amplifier; and
the output network according to any one of claims 1 to 13;
wherein the output network is configured to receive a first amplified signal outputted by the main amplifier and a second amplified signal outputted by the auxiliary amplifier, and the first amplified signal and the second amplified signal are combined at the combination node to be provided to a radio frequency output port of the Doherty amplifier.

15. A design method of a Doherty amplifier, the Doherty amplifier comprising a main amplifier, an auxiliary amplifier, and the output network according to claim 1, wherein the method comprises:
setting a goal performance index of the Doherty amplifier, the goal performance index at least comprising an operating frequency, a saturation power, and a dynamic range of the Doherty amplifier;
according to the goal performance index, selecting transistors for the main amplifier and the auxiliary amplifier;
based on load traction testing or simulation analysis, determining a first goal impedance, a second goal impedance and a third goal impedance, wherein the first goal impedance is the load impedance maximizing an efficiency of the main amplifier when the Doherty amplifier is in a back-off power state, the second goal impedance is the load impedance maximizing an efficiency of the main amplifier when the output power of the main amplifier reaches saturation power, and the third goal impedance is the load impedance maximizing an efficiency of the auxiliary amplifier when the output power of the auxiliary amplifier reaches saturation power; and
based on the first goal impedance, the second goal impedance, and the third goal impedance, determining a circuit topology and element parameters of each sub-network in the auxiliary output network and the main output network, and determining a circuit topology and element parameters of the merging matching network.
